Europäisches Patentamt

European Patent Office

Office européen des brevets

(19)

(11) EP 0 580 836 B1

(12) EUROPÄISCHE PATENTSCHRIFT

(45) Veröffentlichungstag und Bekanntmachung des Hinweises auf die Patenterteilung:
**13.01.1999 Patentblatt 1999/02**

(21) Anmeldenummer: 93903153.0

(22) Anmeldetag: **09.02.1993**

(51) Int Cl.$^6$: **G01R 27/26**

(86) Internationale Anmeldenummer:
**PCT/DE93/00105**

(87) Internationale Veröffentlichungsnummer:
**WO 93/16393 (19.08.1993 Gazette 1993/20)**

(54) **VERFAHREN ZUR QUALITÄTSBESTIMMUNG EINES EINZELNEN SUPRALEITENDEN FILMES UND VORRICHTUNG ZUR DURCHFÜHRUNG DIESES VERFAHRENS**

PROCESS FOR DETERMINING THE QUALITY OF A SINGLE SUPERCONDUCTING FILM AND DEVICE FOR THE IMPLEMENTATION OF THE PROCESS

PROCEDE VISANT A DETERMINER LA QUALITE D'UNE COUCHE SUPRACONDUCTRICE INDIVIDUELLE ET DISPOSITIF DE MISE EN OEUVRE DUDIT PROCEDE

(84) Benannte Vertragsstaaten:
**DE FR GB NL**

(30) Priorität: **14.02.1992 DE 4204369**

(43) Veröffentlichungstag der Anmeldung:
**02.02.1994 Patentblatt 1994/05**

(73) Patentinhaber: **FORSCHUNGSZENTRUM JÜLICH GMBH**
**52425 Jülich (DE)**

(72) Erfinder:
- **KLEIN, Norbert**
  **D-5630 Remscheid (DE)**
- **DÄHNE, Ulrich**
  **D-5100 Aachen (DE)**
- **TELLMANN, Norbert**
  **D-5630 Remscheid 1 (DE)**

(56) Entgegenhaltungen:
- **REVIEW OF SCIENTIFIC INSTRUMENTS Bd. 62, Nr. 7, Juli 1991, NEW YORK,US Seiten 1819 - 1823 , XP240359 BONN 'split-ring resonators for measuring microwave surface resistance of oxide superconductors'**
- **NUCLEAR INSTRUMENTS & METHODS IN PHYSICS RESEARCH A Bd. A295, Nr. 1/2, August 1990, AMSTERDAM.NL Seiten 1 - 4 , XP165813 DELAYEN 'a superconducting quarter wave resonator'**
- **REV. SCI. INSTRUM. Bd. 61, Nr. 8, August 1990, Seiten 2200 - 2206 TABER 'a parallel resonator technique' in der Anmeldung erwaehnt**
- **JOURNAL OF SUPERCONDUCTIVITY Bd. 3, Nr. 3, 1990, Seiten 297 - 304 PORTIS 'rf properties of high-temperature superconductors: cavity methods' in der Anmeldung erwaehnt**
- **JOURNAL OF SUPERCONDUCTIVITY Nr. 3, Maerz 1990, Seiten 251 - 259 OATES 'measurement of surface resistance of YBa2Cu3O(7-x) thin films using stripline resonators' in der Anmeldung erwaehnt**

**Beschreibung**

Die Erfindung betrifft ein Verfahren zur Qualitätsbestimmung, insbesondere zur Bestimmung des Mikrowellen-Oberflächenwiderstandes, eines einzelnen aus einem supraleitenden, insbesondere aus dem Material eines Hochtemperatur-Supraleiters, auf einem Substrat gebildeten Filmes mit Hilfe eines metallischen Hohlraumresonators mit insbesondere kreiszylinderförmigem Innenraum. Des weiteren betrifft die Erfindung eine Vorrichtung zur Durchführung eines solchen Verfahrens.

Seit der Entdeckung keramischer Hochtemperatursupraleiter im Jahre 1986 existieren heutzutage erste Demonstratoren für Anwendungen dieser neuartigen Materialien. Diese liegen z.B. im Bereich passiver Mikrowellen-Bauelemente, sowie im Bereich sogenannter Josephson-Bauelemente. Solche passive Mikrowellen-Bauelemente aus hochtemperatursupraleitenden Materialien sind unter anderem für die Satelitenkommunikation von Bedeutung. Dabei beruhen nahezu alle Anwendungen dieser Art auf epitaktischen Dünnfilmen aus hochtemperatursupraleitenden Materialien, wie sie in vielen Laboratorien auf der ganzen Welt hergestellt werden. Eines der wichtigsten Kriterien für die Qualität solcher Dünnfilme ist der Mikrowellen-Oberflächenwiderstand. Er stellt ein direktes Maß für die noch vorhandenen Mikrowellenverluste in solchen Komponenten dar.

Als Stand der Technik sind grundsätzlich zwei verschiedene Möglichkeiten gegeben den Mikrowellen-Oberflächenwiderstand eines supraleitenden Filmes zu bestimmen.

Es ist z.B. nach D.E. Oates, A.C. Anderson, and P. M. Mankiewich, J. Supercond. 3, 251, 1990 bekannt, mit Hilfe von photolithographischen Techniken aus dem jeweiligen zu untersuchenden Film planare Resonatoren herzustellen. Solche Meßverfahren sind aufwendig und eignen sich daher nicht zu schnellen Qualitätskontrollen von Dünnfilmen.

Eine alternative Art eines Meßverfahrens zur Bestimmung der Qualität eines solchen Dünnfilmes wird in der Arbeit von A.M. Portis, D.W. Cooke, and F.R. Gray, J. Supercond. 3, 297, 1990 zusammengefaßt. Bei diesem Meßverfahren wird eine Wand eines metallischen Hohlraumresonators durch den zu untersuchenden Dünnfilm gebildet. Dabei bedarf ein solches Verfahren keine Vorbehandlung der jeweiligen Probe und ist deshalb zur Qualitätskontrolle geeignet. Dieses Verfahren eignet sich jedoch nur für Frequenzen oberhalb von 50 GHz. Des weiteren ist aus R.C. Taber, Rev. Sci. Instrum. 61, 2200, 1990 ein Verfahren bekannt, bei dem zwei aufeinanderliegende supraleitende Filme einen Parallelplatten-Resonator bilden. Nachteilig ist jedoch, daß stets der Mittelwert des Oberflächenwiderstandes zweier Filme gemessen wird. Außerdem kann nicht der gesamte Temperaturverlauf des Oberflächenwiderstandes bis zur Sprungtemperatur bestimmt werden.

Aufgabe der vorliegenden Erfindung ist es ein Verfahren, sowie eine Vorrichtung zur Durchführung des Verfahrens zu schaffen, das die Qualitätskontrolle einzelner Dünnfilme, insbesondere aus supraleitendem Material mit hoher Empfindlichkeit und ohne die gemäß dem Stand der Technik gegebenen Nachteile ermöglicht.

Diese Aufgabe wird gelöst durch ein Verfahren, bei dem der supraleitende Film als ein Teil einer der Wandungen des Hohlraumresonators mit der Wandung des Hohlraumresonators verbunden wird. Mit dem supraleitenden Film wird ein Dielektrikum flächenhaft verbunden. Dabei leitet eine mit der insbesondere zylindrischen Wandung verbundene Einkoppelantenne Mikrowellen in den Innenraum des Hohlraumresonators, eine weitere, insbesondere der Einkoppelantenne gegenüberliegende, mit dem Hohlraumresonator verbundene Auskoppelantenne Signale aus dem Innenraum des Hohlraumresonators heraus. Die so herausgeleiteten Signale werden dabei in bekannter Weise insbesondere zur Bestimmung des Mikrowellen-Oberflächenwiderstandes des supraleitenden Filmes weiterverarbeitet. Die Qualitätsbestimmung des supraleitenden Filmes kann aber auch darin liegen, daß das ausgekoppelte Mikrowellensignal zur Bestimmung der Eindringtiefe des Magnetfeldes weiterverarbeitet wird. Besonders vorteilhaft erweist sich das Verfahren bei der Qualitätsbestimmung eines supraleitenden Filmes, aus dem Material eines Hochtemperatursupraleiter.

Gegenüber bekannten Hohlraumresonatorverfahren zeigt das erfindungsgemäße Verfahren den Vorteil, daß der Hohlraum zum Teil mit einem Dielektrikum gefüllt ist, was sowohl zu einer Verkürzung der Abmessungen des Hohlraumes als auch zu der Möglichkeit führt, bei tieferen Frequenzen zu messen. Ein weiterer Vorteil des erfindungsgemäßen Verfahrens liegt in der Verstärkung der elektromagnetischen Felder an der Filmoberfläche aufgrund der flächenhaften Berührung des Dielektrikums mit dem supraleitenden Film. Eine Abschwächung dieser elektromagnetischen Felder an den übrigen Wänden des Resonators wird dadurch in vorteilhafter Weise erreicht.

Eine vorteilhafte Variante des erfindungsgemäßen Verfahrens ist gegeben durch den Kennzeichnungsteil des Anspruchs 2. Für den Fall, daß der supraleitende Film einen Teil der unteren Wandung des Resonators bildet, reicht es zwecks Ankopplung der elektromagnetischen Felder an dem supraleitenden Film aus, das Dielektrikum flächenhaft mit dem supraleitenden Film zu verbinden, indem das Dielektrikum lose auf diesen Film aufgesetzt wird. Diese Maßnahme erlaubt eine zerstörungsfreie Qualitätsbestimmung des supraleitenden Films. Ein weiterer Vorteil dieser Maßnahme könnte darin liegen, daß die Qualitätsbestimmung nacheinander an verschiedenen Stellen des zu untersuchenden supraleitenden Filmes durch einfaches Verschieben des Dielektrikums erfolgen kann.

Besonders vorteilhaft ist es in einer gemäß Anspruch 3 vorgeschlagenen Weise, als Dielektrikum Sa-

phir oder Lanthan-Aluminat ($LaAlO_3$) zu wählen. Es ist selbstverständlich, daß auch andere Materialien als Dielektrikum gewählt werden können. Sie sollten wie z.B. der hier erwähnte Saphir zu der Klasse der Dielektrika mit hoher dielektrischen Konstante aber geringen dielektrischen Verlusten gehören. In vorteilhafter Weise steigt mit der Wahl eines Materials mit einer höheren dielektrischen Konstante die Konzentration der elektromagnetischen Felder an der supraleitenden Filmoberfläche und eine damit verbundene Abschwächung solcher elektromagnetischen Felder an den übrigen Wänden des Hohlraumresonators.

Es ist vorteilhaft als geometrische Form des Dielektrikums im erfindungsgemäßen Verfahren im Sinne des Anspruchs 4 einen Zylinder zu wählen.

Zur Weiterverarbeitung des von der Auskoppelantenne abgestrahlten Mikrowellensignals und zur Bestimmung des Oberflächenwiderstandes $R_{Film}$ (T) des supraleitenden Filmes ist bei einem Hohlraumresonator mit Resonanzfrequenz f folgende Beziehung zwischen dem Gütefaktor Q, dem Oberflächenwiderstand des Filmes $R^{Film}$ (T), dem Oberflächenwiderstandes des Resonatormaterials $R^{Cu}$ (T) - insbesondere Kupfer - sowie zwei Geometriefaktoren $G_{Film}$ und $G_{Resonator}$ gegeben.

$$\frac{1}{Q} = \frac{R^{Film}(T)}{G_{Film}} + \frac{R^{Cu}(T)}{G_{Resonator}}$$

Zur Bestimmung des Oberflächenwiderstandes $R_{Film}$ (T) des supraleitenden Filmes ist es im Vorfeld der Bestimmung dieser Größe erforderlich über zwei Referenzmessungen den Geometriefaktor $G_{Resonator}$ sowie den temperaturabhängigen Verlauf des Oberflächenwiderstandes $R^{Cu}$ des Hohlraumresonators zu bestimmen.

In einer ersten Referenzmessung wird zunächst der Term $R^{Cu}$ (2K) dividiert durch $G_{Resonator}$ ermittelt. In vorteilhafter Weise kann dazu ein mit einem Niob--Film versehenes Substrat eingesetzt werden. Außer Niob könnten aber auch andere, bei einer Temperatur von T=2K gewählt werden, sofern der Oberflächenwiderstand eines solchen Materials bei dieser Temperatur klein gegenüber dem Widerstand des zu untersuchenden supraleitenden Filmes ist.

In einer weiteren, zweiten Referenzmessung wird dann die Temperaturabhängigkeit des Termes $R^{Cu}$ (T) dividiert durch $G_{Resonator}$ ermittelt, so daß der Geometriefaktor $G_{Film}$ des zu untersuchenden supraleitenden Filmes bestimmt werden kann.

Aus der Beziehung

$$Q(T) = \frac{f}{\delta f_{1/2}}$$

läst sich der Gütefaktor Q (T) in Abhängigkeit der Temperatur über die Ermittlung der Halbwertsbreite $\delta f_{1/2}$

der gemessenen Resonanzkurve ermitteln.

Die erfindungsgemäße Aufgabe wird zudem durch eine Vorrichtung der eingangs bezeichneten Art gelöst, die die Merkmale des Kennzeichnungsteils des Anspruchs 5 aufweist.

Weitere zweckmäßige und/oder vorteilhafte Ausführungsformen dieser Vorrichtung ergeben sich aus den Ansprüchen 9 bis 13. Eine besonders vorteilhafte Ausführungsform der erfindungsgemäßen Vorrichtung ergibt sich dann, wenn als Material zur Bildung des Hohlraumresonators Niob vorgesehen ist. Gegenüber einen aus z.B. Kupfer gebildeten Hohlraumresonators trägt die innere Wandung eines aus Niob bestehenden Hohlraumresonators dazu bei, daß die Mikrowellenverluste an der inneren Wandung des Hohlraumresonators weiter verringert werden.

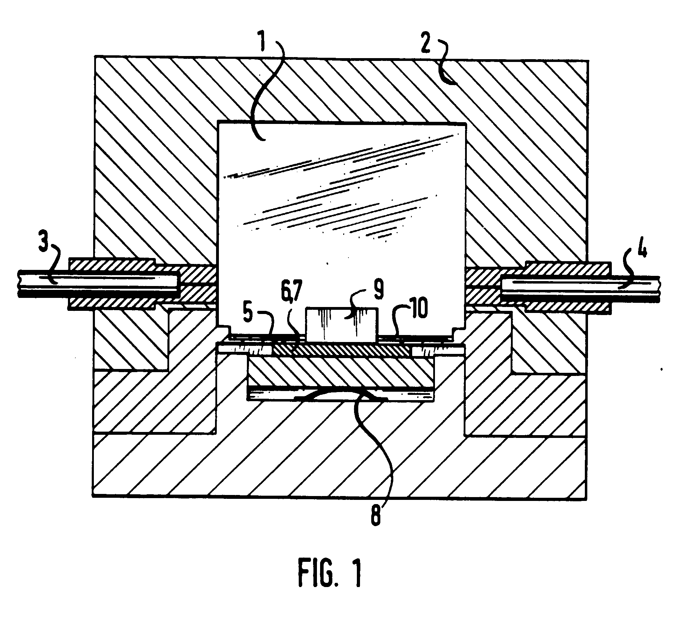

Zur näheren Erläuterung der erfindungsgemäßen Vorrichtung ist in der Figur 1 im Querschnitt, schematisch, eine solche Vorrichtung gezeigt.

In den Innenraum 1 eines aus Kupfer bestehenden Hohlraumresonators 2 sind eine Einkoppelantenne 3 sowie eine Auskoppelantenne 4 eingeführt worden. An einer Öffnung 5 der Wandung des Innenraumes 1 des Hohlraumresonators 2 ist der mit einem Substrat 6 verbundene zu untersuchende supraleitende Film 7 an die Öffnung 5 von außerhalb des Innenraumes herangeführt worden. Zweckmäßigerweise sorgt eine Feder 8 für die bleibende Lokalisierung des Filmes während der Qualitätsbestimmung. Auf dem zu untersuchenden supraleitenden Film 7 liegt das zylinderförmige, aus Saphir bestehende Dielektrikum 9 flächenhaft auf dem zu untersuchenden supraleitenden Film 7 auf. Wie die Darstellung in der Figur 1 zeigt, erweist es sich als zweckmäßig, das mit seiner Stirnfläche auf dem Film aufliegende Dielektrikum 9 mit einer geeignet geformten, aus Quartz gebildeten Halterung 10 relativ zum zu untersuchenden Film lateral definiert zu positionieren.

In an sich bekannter Weise erfolgt die Einkopplung von Mikrowellen mit Hilfe der Einkoppelantenne 3. Das Mikrowellensignal wird von der Auskoppelantenne 4 aus den Innenraum zwecks Weiterverarbeitung herausgeführt.

Bei einer Resonanz von 18,7 GHz wird eine Empfindlichkeit in der Bestimmung des Mikrowellen-Oberflächenwiderstandes des zu untersuchenden Filmes von $\pm$ 5 x $10^{-5}$ Ohm erreicht. Das erfindungsgemäße Verfahren und die zur Durchführung dieses Verfahrens erfindungsgemäße Vorrichtung, gestatten die Charakterisierung einzelner supraleitender Filme, deren Durchmesser einen Wert von 0,5 cm bis zu 3 cm, z.B. 1 cm oder 2 cm, hat. Mit diesem Verfahren können supraleitende Filme mit Oberflächenwiderständen bis zu Werten von 2 Ohm gemessen werden.

In einem Kryostaten angeordnet, erlaubt der Gegenstand der Erfindung die Bestimmung des Mikrowellen-Oberflächenwiderstandes, supraleitender Filme im Temperaturbereich von 2K bis zu 300K. Selbstverständlich wäre eine solche Anordnung nicht auf diesen Temperaturbereich beschränkt. Das zylinderförmige aus Saphir bestehende Dielektrikum hat einen Durchmesser von 6 mm, und eine Höhe von 3 mm. Der Innenraum des Hohlraumresonators in Figur 1 ist 1,5 cm hoch und 2,0 cm im Durchmesser. Im übrigen stellen die angegebenen Extremwerte für Oberflächenwiderstand, Temperatur und Abmessung keine Grenzen. Vielmehr ist das Verfahren auch bei anderen als die hier angegebenen Werte einsetzbar.

## Patentansprüche

1. Verfahren zur Qualitätsbestimmung, insbesondere zur Bestimmung des Mikrowellen-Oberflächenwiderstandes, eines einzelnen aus einem supraleitenden, auf einem Substrat gebildeten Filmes (7) mit Hilfe eines metallischen Hohlraumresonators (2) mit insbesondere kreiszylinderförmigem Innenraum (1), bei dem der supraleitende Film (7) als zumindest ein Teil einer der Wandungen dieses Hohlraumresonators (2) mit der Wandung des Hohlraumresonators verbunden wird, **dadurch gekennzeichnet,** daß

 - ein Dielektrikum (9) mit dem supraleitenden Film (7) flächenhaft verbunden wird und
 - eine mit der insbesondere zylindrischen Wandung verbundene Einkoppelantenne (3) Mikrowellen in den Innenraum des Hohlraumresonators, eine weitere, mit dem Hohlraumresonator verbundene Auskoppelantenne (4) Signale zwecks Weiterverarbeitung, insbesondere zur Bestimmung des Mikrowellen-Oberflächenwiderstandes des supraleitenden Filmes aus dem Innenraum des Hohlraumresonators leitet.

2. Verfahren nach Anspruch 1, **dadurch gekennzeichnet** daß für den Fall, daß der supraleitende Film (7) einen Teil der unteren Wandung des Hohlraumresonators bildet, das Dielektrikum (9) auf diesem Film lösbar aufgesetzt wird.

3. Verfahren nach Anspruch 1 oder 2, **dadurch gekennzeichnet,** daß als Dielektrikum (9) Saphir oder LaAlO$_3$ gewählt wird.

4. Verfahren nach Anspruch 1, 2 oder 3, **dadurch gekennzeichnet,** daß als Form des Dielektrikums (9) ein Zylinder gewählt wird.

5. Verfahren nach einem der Ansprüche 1 bis 4, **dadurch gekennzeichnet,**

daß die Einkoppelantenne (3) der Auskoppelantenne (4) gegenüberliegend angeordnet wird.

6. Verfahren nach einem der vorherigen Ansprüche, **dadurch gekennzeichnet,** daß als Material des supraleitenden Filmes (7) ein Hochtemperatursupraleiter gewählt wird.

7. Verfahren nach einem der vorherigen Ansprüche, **dadurch gekennzeichnet,** daß als Material des supraleitenden Filmes (7) YBaCuO gewählt wird.

8. Vorrichtung mit einem metallischen Hohlraumresonator (2) mit insbesondere kreiszylinderförmigem Innenraum (1) zur Durchführung eines Verfahrens zur Qualitätsbestimmung eines einzelnen supraleitenden, auf einem Substrat (6) gebildeten Filmes (7), **gekennzeichnet durch**

 - eine in der insbesondere zylinderförmigen Wandung dieses Innenraums angeordnete, erste Antenne (3) zwecks Ankopplung von Mikrowellen in den Hohlraumresonator hinein,
 - eine weitere, in der insbesondere zylinderförmigen Wandung dieses Innenraums angeordnete Antenne (4) zwecks Auskopplung von Mikrowellensignalen zur Weiterverarbeitung, insbesondere zur Bestimmung des Mikrowellen-Oberflächenwiderstandes des supraleitenden Filmes aus dem Hohlraumresonator heraus,
 - eine am Hohlraumresonator in einer der anderen den Innenraum des Resonators begrenzenden Wandungen, insbesondere an der Stirnfläche des kreiszylinderförmigen Innenraums, vorhaudene Öffnung (5), an der das mit dem supraleitenden Film verbundene Substrat (6) so anliegt, daß der Film außerhalb des Innenraums an der Öffnung die Wandung des Hohlraumresonators bildet und dabei die filmbeschichtete Seite des Substrats dem Innenraum des Hohlraumresonators zugewendet ist und
 - ein den supraleitenden Film (7) auf dem Substrat (6) zumindest teilweise bedeckendes Dielektrikum (9).

9. Vorrichtung nach Anspruch 8, **gekennzeichnet durch** eine zylindrische, mit seiner Grundfläche auf dem supraleitenden Film (7) flächenhaft aufliegende Ausbildung des Dielektrikums (9).

10. Vorrichtung nach Anspruch 8 oder 9, **gekennzeichnet durch** Saphir oder LaAlO$_3$ als Material zur Bildung des Dielektrikums (9).

**11.** Vorrichtung nach einem der Ansprüche 8 bis 10, **dadurch gekennzeichnet,** daß als Material zur Bildung des Hohlraumresonators (2) Niob vorgesehen ist.

**12.** Vorrichtung nach einem der Ansprüche 8 bis 11, **dadurch gekennzeichnet,** daß als Material des supraleitenden Filmes (7) ein Hochtemperatursupraleiter vorgesehen ist.

**13.** Vorrichtung nach einem der Ansprüche 8 bis 12, **dadurch gekennzeichnet,** daß die Einkoppelantenne (3) der Auskoppelantenne (4) gegenüberliegend angeordnet ist.

**Claims**

**1.** Process for determining the quality, in particular for determining the microwave surface resistance, of an individual superconducting film (7) formed on a substrate, with the aid of a metallic cavity resonator (2), in particular with a circular cylindrical interior space (1), in which the superconducting film (7) is, at least as a portion of one of the walls of this cavity resonator (2), connected to the wall of the cavity resonator, **characterised in that**

- a dielectric (9) is surface connected to the superconducting film (7), and
- an input antenna (3), which is connected in particular to the cylindrical wall, ducts microwaves into the interior space of the cavity resonator, and a further output antenna (4), which is connected to the cavity resonator, ducts signals for further processing, in particular for determining the microwave surface resistance of the superconducting film, from the interior space of the cavity resonator.

**2.** Process according to Claim 1, **characterised in that**, in the event that the superconducting film (7) forms part of the lower wall of the cavity resonator, the dielectric (9) is releasably placed onto this film.

**3.** Process according to Claim 1 or 2, **characterised in that** saphire or $LaAlO_3$ is chosen as dielectric (9).

**4.** Process according to Claim 1, 2 or 3, **characterised in that** a cylinder is selected as a form of the dielectric (9).

**5.** Process according to one of Claims 1 to 4, **characterised in that** the input antenna (3) is arranged opposite the output antenna (4).

**6.** Process according to one of the above claims, **characterised in that** the material of the superconducting film (7) is a high-temperature superconductor.

**7.** Process according to one of the above claims, **characterised in that** the material of the superconducting film (7) is YBaCuO.

**8.** Device with a metallic cavity resonator (2), in particular with circular cylindrical interior space (1) for carrying out the process of determining the quality of an individual superconducting film (7) formed on a substrate (6), **characterised by**

- a first antenna (3), in particular one arranged in the cylindrical wall of this interior space, for the purpose of inputting microwaves into the cavity resonator;
- a further antenna (4), in particular arranged in the cylindrical wall of this interior space, for the purpose of outputting microwave signals for further processing, in particular for determining the microwave surface resistance of the superconducting film from the cavity resonator;
- an opening (5) on the cavity resonator in one of the other walls which define the interior area of the resonator, in particular at the end surface of the circular cylindrical interior area, to which the substrate (6) which is connected to the superconducting film abuts in such a manner that the film forms the wall of the cavity resonator outside the interior area at the opening, and the film-coated side of the substrate is facing towards the interior area of the cavity resonator; and
- a dielectric (9) which at least partially covers the superconducting film (7) on the substrate (6).

**9.** Device according to Claim 8, **characterised by** a cylindrical design of the dielectric (9) which abuts the superconducting film (7) with its base surface.

**10.** Device according to Claim 8 or 9, **characterised by** saphire or $LaALO_3$ as material for establishing the dielectric (9).

**11.** Device according to one of Claims 8 to 10, **characterised in that** Niob is provided as a material for forming the cavity resonator (2).

**12.** Device according to one of Claims 8 to 11, **characterised in that** a high-temperature superconductor is provided as material for the superconducting film (7).

**13.** Device according to one of Claims 8 to 12, **characterised in that** the input antenna (3) is positioned opposite the output antenna (4).

## Revendications

1. Procédé pour déterminer la qualité, notamment pour déterminer la résistance superficielle hyperfréquence, d'une pellicule (7) individuelle supraconductrice, formée sur un substrat, à l'aide d'une cavité (2) résonante métallique dont l'intérieur (1) est notamment cylindrique circulaire, dans lequel la pellicule (7) supraconductrice est reliée en tant qu'au moins une partie des parois de cette cavité (2) résonante à la paroi de la cavité résonante, caractérisé en ce que

   - un diélectrique (9) est accolé surface contre surface à la pellicule (7) supraconductrice et
   - une antenne (3) d'entrée reliée à la paroi, notamment cylindrique, envoie des micro-ondes à l'intérieur de la cavité résonante, une antenne (4) de sortie supplémentaire, reliée à la cavité résonante, fait sortir, à des fins de traitement ultérieur, notamment pour déterminer la résistance superficielle hyperfréquence de la pellicule supraconductrice, des signaux de l'intérieur de la cavité résonante.

2. Procédé suivant la revendication 1, caractérisé en ce que, dans le cas où la pellicule (7) supraconductrice forme une partie de la paroi inférieure de la cavité résonante, le diélectrique (9) est posé de manière amovible sur cette pellicule.

3. Procédé suivant la revendication 1 ou 2, caractérisé en ce que l'on choisit comme diélectrique (9) du saphir ou du LaAlO$_3$.

4. Procédé suivant la revendication 1, 2 ou 3, caractérisé en ce que l'on choisit comme forme du diélectrique (9) un cylindre.

5. Procédé suivant l'une des revendications 1 à 4, caractérisé en ce que l'antenne (3) d'entrée est montée en face de l'antenne (4) de sortie.

6. Procédé suivant l'une des revendications précédentes, caractérisé en ce que l'on choisit un supraconducteur à haute température comme matériau de la pellicule supraconductrice.

7. Procédé suivant l'une des revendications précédentes, caractérisé en ce que l'on choisit YBaCuO comme matériau de la pellicule supraconductrice.

8. Dispositif comportant une cavité (2) résonante métallique, dont l'intérieur (1) est notamment cylindrique circulaire, pour mettre en oeuvre un procédé de détermination de la qualité d'une pellicule (7) individuelle supraconductrice, formée sur un substrat (6),

caractérisé par

   - une première antenne (3), montée dans la paroi, notamment cylindrique, de cette cavité, servant à envoyer des micro-ondes dans la cavité résonante,
   - une antenne (4) supplémentaire, montée dans la paroi, notamment cylindrique, de cette cavité, pour faire sortir de la cavité résonante des signaux hyperfréquence en vue d'un traitement ultérieur, notamment pour la détermination de la résistance superficielle hyperfréquence de la pellicule supraconductrice,
   - une ouverture (5) qui est présente sur la cavité résonante, sur l'une des autres parois délimitant la cavité du résonateur, notamment sur la surface frontale de la cavité cylindrique circulaire et à laquelle le substrat (6) muni de la pellicule supraconductrice s'applique de telle manière que la pellicule forme sur l'ouverture, à l'extérieur de la cavité, la paroi de la cavité (2) résonante, le côté du substrat muni de la pellicule étant tourné vers l'intérieur de la cavité résonante, et
   - un diélectrique (9) recouvrant au moins en partie la pellicule (7) supraconductrice sur le substrat (6).

9. Dispositif suivant la revendication 8, caractérisé par une conformation cylindrique, reposant surface contre surface par sa face de base sur la pellicule (7) supraconductrice, du diélectrique (9).

10. Dispositif suivant la revendication 8 ou 9, caractérisé par du saphir ou du LaAlO$_3$ comme matériau pour former le diélectrique (9).

11. Dispositif suivant l'une des revendications 8 à 10, caractérisé en ce qu'il est prévu du niobium comme matériau pour former la cavité (2) résonante.

12. Dispositif suivant l'une des revendications 8 à 11, caractérisé en ce qu'il est prévu un supraconducteur à haute température comme matériau de la pellicule (7) supraconductrice.

13. Dispositif suivant l'une des revendications 8 à 12, caractérisé en ce que l'antenne (3) d'entrée est montée en face de l'antenne (4) de sortie.

FIG. 1